# EUROPEAN PATENT APPLICATION

(11) **EP 0 851 479 A1**
(43) Date of publication of application: **01.07.1998**
(21) Application number: 96830644.9
(22) Date of filing: 24.12.1996
(51) Int. Cl.: H01L 21/768, H01L 21/31, H01L 21/3105, H01L 21/316

(54) **Process for deposing a multiple dielectric structure for enhancing the planarity of semiconductor electronic devices**

(71) Applicant: SGS-THOMSON MICROELECTRONICS s.r.l., 20041 Agrate Brianza (Milano) (IT)
(72) Inventor: Sonego, Patrizia, 20100 Milano (IT); Colabella, Elio, 20100 Milano (IT); Bacchetta, Maurizio, 20093 Cologno Monzese (Milano) (IT); Pividori, Luca, 10100 Torino (IT)
(74) Representative: Checcacci, Giorgio

(57) **Abstract**

A method of depositing a dielectric ply structure to optimize the planarity of electronic devices which include a plurality of active elements having gate regions laid across the substrate as discrete parallel lines, such as the bit lines of memory cells.

The proposed solution in accordance with the principles of this invention allows the plurality of bit lines to be isolated from one another by a suitable dielectric ply structure to provide a planar architecture onto which an optional conductive layer may be deposited.

A plurality of word lines can be formed from the conductive layer by conventional photolithographic and dry-wet etching processes.

These lines intersect the plurality of bit lines to define a plurality of EPROM cells organized into a matrix-like topography.

The resulting planarization is adequate to avoid the typical shortcomings of the prior art, such as the lack of electrical continuity in the word lines or their excessively high electrical resistance from slenderized portions in the conductive sections due to poor planarity of the surfaces whereon the conductive layer is deposited.

## Description

### Field of Invention

This invention relates to a method of depositing a multiple dielectric ply structure in order to improve the planarity of electronic devices integrated on a semiconductor substrate, such devices comprising a plurality of active elements which have gate regions extending across the substrate as discrete parallel lines, e.g. as bit lines of memory cells, said lines being isolated from one another by a first dielectric layer which also fills the gaps therebetween.

The invention also concerns a dielectric ply structure for planarizing electronic devices integrated on a semiconductor substrate; such devices comprising a plurality of active elements which have gate regions extending across the substrate as discrete parallel lines, e.g. as bit lines of memory cells, said lines being isolated from one another by a first dielectric layer which also fills the gaps therebetween.

In particular, but not exclusively, the invention relates to a method of depositing a dielectric ply structure in order to improve the planarity of integrated electronic devices which include EPROM or E²PROM memory cells defined by the intersections of bit lines and word lines, and the description to follow will make reference to this field of application as a matter of example.

### Background Art

As is well known, the fabrication of integrated electronic devices on semiconductor substrates always requires that circuit topographies, which have been transferred by conventional photolithographic and dry or wet etching techniques, be checked for the occurrence of critical architectures which might impair a reliable operation of a formed component.

In particular, this test is necessary where a conductive layer is to be deposited onto a surface less than truly planar, showing local discontinuities or depressions.

In fact, the conductive layer may have its cross-section so slenderized, due to poor adhesion on the deposited underlayer, as to develop in some cases mechanical ruptures resulting in loss of electrical continuity.

A typical instance is that of a plurality of active elements, having gate regions which extend across the substrate as discrete parallel lines, e.g. in the form of floating gate lines, requiring reduction to a planar type of architecture preparatory to receiving, as by deposition, a conductive overlayer.

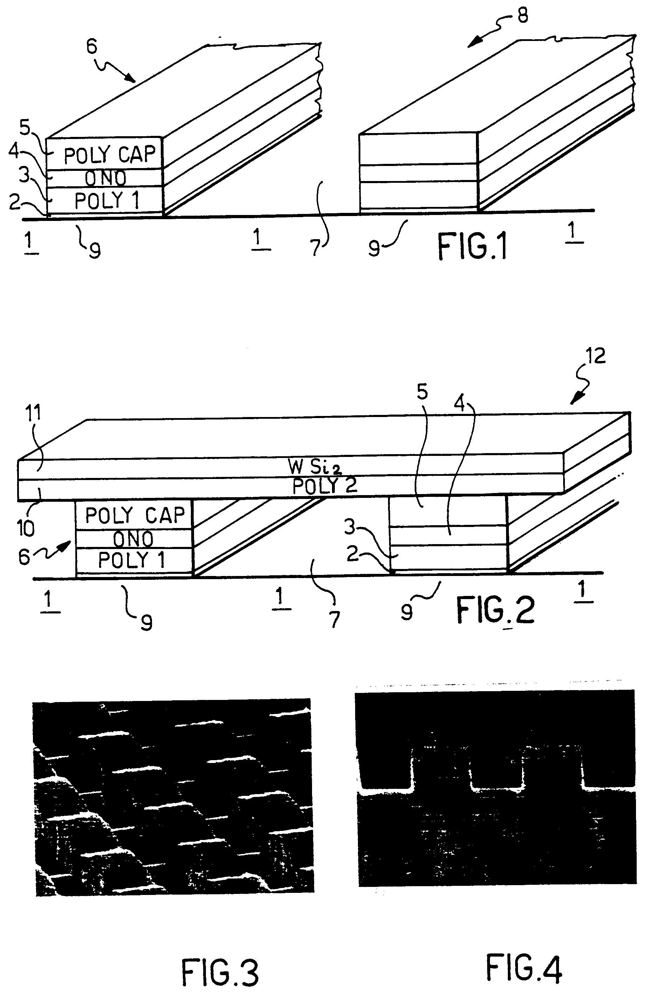

On analysing a vertical cross-section of the above-mentioned semiconductor substrate under an electronic microscope, a typical square-wave profile can be observed, as shown in Figure 4, which is unsuitable to receive a deposition of conductive material thereon, for the reasons just given.

To avoid such problems, the conductive layer deposition must be preceded by a planarity optimization step effective to provide a less discontinuous cross-sectional profile of the semiconductor substrate.

Merely as a matter of example, consider an instance where a plurality of floating gates are to be orthogonally intersected by a plurality of strips of a conductive material to define a topography of the matrix type, that is a typical structure of semiconductor storage circuits.

In this specific application, the plurality of parallel lines including the floating gates will be referred to as the "bit lines", and the plurality of conductive strips referred to as the "word lines", hereinafter.

In connection with the aforementioned example, a number of problems would be incurred if no planarization step is carried out prior to forming the plurality of word lines orthogonally intersecting the bit lines.

A first problem is posed by the inherent nature of the conductive layers which, once deposited, tend to distribute themselves unevenly across the semiconductor substrates, thereby developing discontinuous profiles wherein areas of substantial thickness alternate with thinner areas.

This feature is the more pronounced, the more discontinuous is the semiconductor cross-section profile.

The deposition areas of the conductive layer where thickness is least are susceptible to mechanical ruptures that destroy the electrical continuity of the layer.

Another problem shows up when the plurality of regions in the semiconductor substrate, bounded by the bit lines, must be isolated electrically from the conductive layer deposited.

In fact, the thermal growth of an isolation oxide may become necessary in the spaces separating the bit lines, which contributes a further diminished vertical cross-section of the conductive layer, thereby increasing the resistance associated with the word lines.

Word lines are formed from the deposited conductive layer by conventional photolithographic and either wet or dry etching operations.

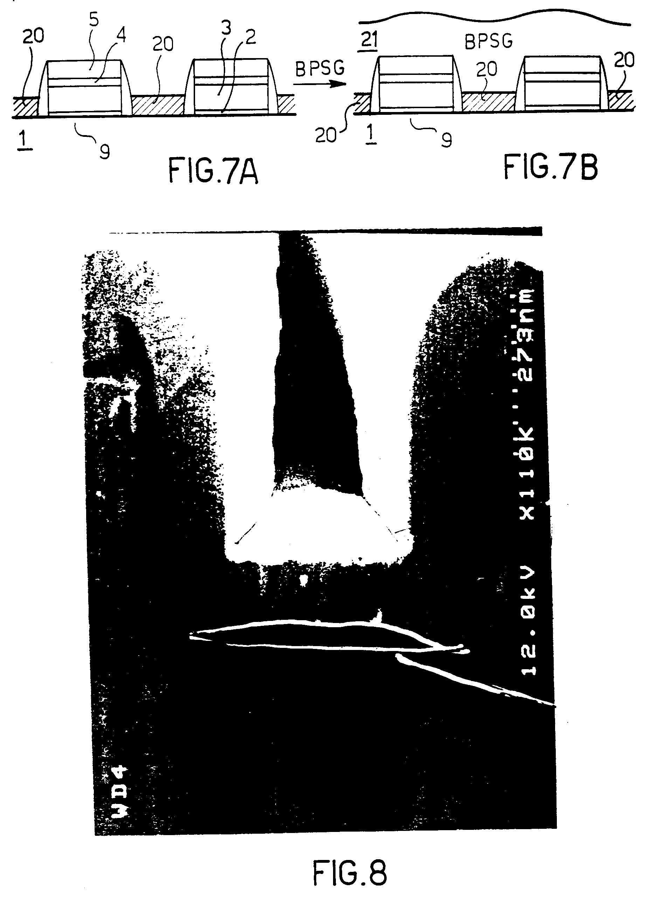

Figure 8 is an enlarged scale view obtained from a photograph taken at the electronic microscope, showing schematically a vertical cross-section through a semiconductor substrate with a plurality of bit lines integrated thereon which have been isolated from one another by a deposition of dielectric oxide, and capped with a conductive layer.

This figure highlights another problem which typically associates in these devices with the deposition of the conductive layer.

This problem is noticeable in the black region at the picture top.

That region actually shows slenderized portions near a white area identifying the oxide layer which separates the bit line from the conductive layer. These slenderized portions may result in short circuits occurring between active regions of the semiconductor substrate, beneath the plurality of bit lines and word lines.

It should be further noted that the topographic definition of the word lines, as obtained with photolithographic and either wet or dry etching operations performed on the conductive layer, can cause deformations in the floating gates as a result of the reiterate flushing involved in thoroughly removing the conductive layer from the regions not protected with a resist.

A first known proposal for planarizing semiconductor substrates having a plurality of floating gates is disclosed in a Patent Application No. VA/000117/IN entitled "Processo EPROM a tovaglia" ("A Tablecloth EPROM Process") filed by S. Mazzoli, M. Melanotte, L. Masini, M. Sali in 1989.

This document proposes of isolating the plurality of floating gates from one another by depositing a first dielectric layer of the TEOS (TetraEthylOrthoSilicate) type.

The thickness of the TEOS growth is quite substantial, being illustratively three times as great as the step between the substrate and the upper portion of the individual bit lines.

A second dielectric layer of the SOG (Spin-On Glass) type is then deposited onto this first dielectric layer in order to planarize the surface of the semiconductor substrate.

Thereafter, the planarized surface is subjected to selective etching in the respect of the polysilicon, thereby to thoroughly remove the SOG dielectric layer and confine the TEOS layer to the gaps between the plurality of floating gates.

However, this proposal has a serious drawback in that wet or dry etching steps are used to remove the excess insulating dielectric, which steps are hardly repeatable and result in the planarity previously achieved through the deposition of the SOG type of dielectric layer being deteriorated.

Additionally to the above, the deposition of dielectric layers of the TEOS type is always accompanied by the formation of micro-voids or cracks from stresses within the grown material, whereby undesired contacts may be established between contiguous deposited layers, just as previously shown in Figure 8.

The above observation is confirmed in an article "Planarized SiO₂ Interlayer Formed by Two Step O₃/TEOS APCVD and Low Temperature Annealing" by Koji Kishimoto, Mieko Suzuki, Takeshi Hirayama, Yasuo Ikeda, and Youichirou Numasawa of NEC Corporation, June 9-10, 1992, page 150, line 10, emphasizing the impossibility of using TEOS-type dielectric layers of substantial thickness, due to the occurrence of mechanical failures which can only be avoided by adopting more elaborate growth methods.

The underlying technical problem of this invention is to provide a method of depositing a dielectric ply structure, effective to planarize a semiconductor substrate laid with a plurality of spaced bit lines, so as to accommodate the optional deposition of an overlying conductive layer and overcome the aforementioned limitations and drawbacks besetting the prior art.

### Summary of the Invention

The solvent idea on which the instant invention stands is to use a dielectric ply structure which comprises a first dielectric layer effective to isolate the plurality of bit lines from one another, and a second dielectric layer effective to planarize the semiconductor substrate surface by means of rapid thermal annealing treatments.

Based on this solvent idea, the technical problem is solved by a deposition method as defined in the characterizing portion of the appended Claim 1 foll..

This solvent idea has also prompted the provision of a dielectric ply structure, characterized in that it comprises:
a second, planarization dielectric layer of the BPSG type to completely cover said first isolating dielectric layer.

By this method and dielectric structure, the limitations and drawbacks of the prior art are removed which interfered with the obtainment of sufficient levels of semiconductor substrate planarity to allow of the deposition of a conductive layer thereon.

The features and advantages of the inventive device will be apparent from the following description of an embodiment thereof, given by way of non-limitative example with reference to the accompanying drawings.

### Brief Description of the Drawings

Figure 1 is a perspective view, drawn to an enlarged scale, showing schematically an electronic device integrating a plurality of spaced bit lines on a semiconductor substrate.

Figure 2 is a perspective view, drawn to an enlarged scale, showing schematically an electronic device integrating a plurality of spaced bit lines on a semiconductor substrate which are intersected at the top by a plurality of word lines.

Figure 3 is derived from a photograph, taken at the electronic microscope, of a plurality of EPROM memory cells having a matrix-like topography resulting from intersecting bit and word lines.

Figure 4 is derived from a photograph, taken at the electronic microscope, of a square-wave profile associated with a semiconductor substrate that integrates a plurality of bit lines.

Figures 5A and 5B show schematically, to an enlarged scale, a vertical cross-section through a semiconductor electronic device during a step of depositing a planarized dielectric layer, starting from a TEOS-SOG ply dielectric structure, according to the prior art.

Figures 6A and 6B show schematically, to an enlarged scale, a vertical cross-section through a semiconductor electronic device during a step of depositing a TEOS-BPSG ply dielectric structure, in accordance with the principles of this invention.

Figures 7A and 7B show schematically, to an enlarged scale, a vertical cross-section through a semiconductor electronic device during a step of depositing an oxide-BPSG dielectric structure, in accordance with a possible modification of the inventive deposition method.

Figure 8 is derived from a photograph, taken at the electronic microscope, of a plurality of bit lines as integrated on a semiconductor substrate and isolated by an oxide layer from a deposition of a conductive layer thereon.

Figure 9 is derived from a photograph, taken at the electronic microscope, of a conductive layer as deposited onto an architecture which has been planarized with a dielectric structure according to the invention and has its level of planarity diminished as a result of subsequent flushing with aqueous-acidic solutions.

Figures 10A and 10B show schematically, to an enlarged scale, a vertical cross-section through a semiconductor electronic device as planarized with the method of this invention through an additional step of depositing a conductive layer comprised of multiple films.

Figure 11 is derived from a photograph, taken at the electronic microscope, of a vertical cross-section through a semiconductor architecture as planarized by a dielectric ply structure according to the invention.

Figures 12A-12C show schematically, to an enlarged scale, a vertical cross-section through a semiconductor electronic device lacking the protection of spacer elements, during a step of depositing a TEOS-BPSG ply dielectric structure in accordance with the principles of this invention.

### Detailed Description

Referring to the drawing figures, generally shown at 1 is a perspective view of a semiconductor substrate integrating a plurality of bit lines 6 which are laid parallel to, and at a spacing from, one another (also referred to above as the plurality of floating gates).

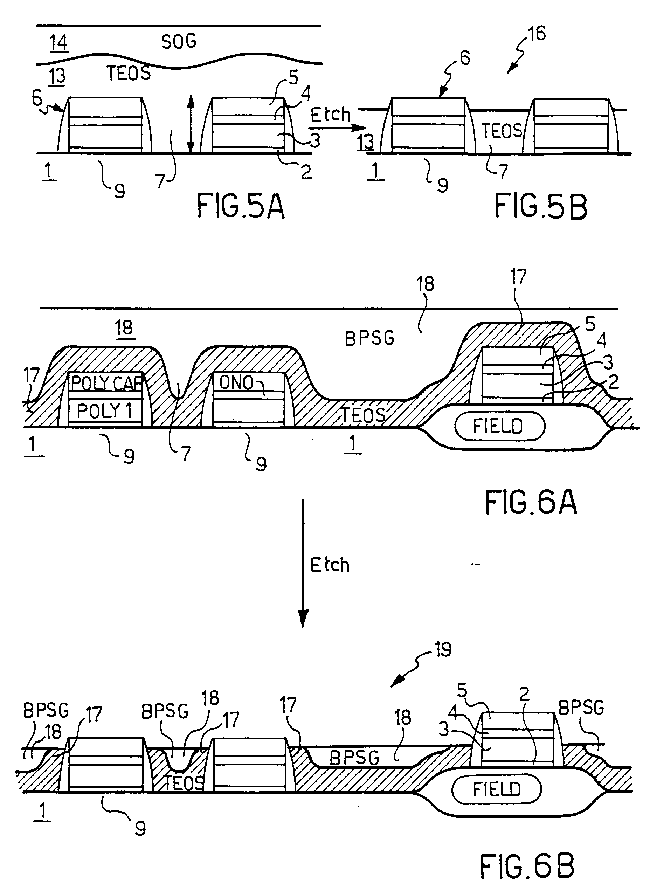

The following description will make specific reference to Figures 6A and 6B, where bit lines are protected laterally by intentional leftovers of dielectric material called the 'spacers'.

The spacers can be formed by depositing a layer of silicon nitride or TEOS over the substrate and bit lines, followed by an isotropic etching step.

However, the skilled persons in the art will appreciate that the provision of spacers is no strict condition to the implemention of this invention.

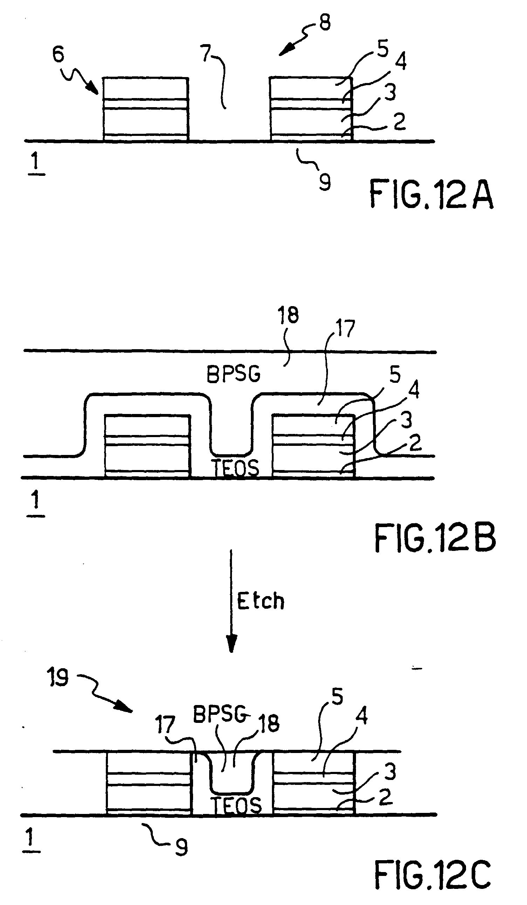

Accordingly, the following description may also make reference to Figures 12A, 12B and 12C, where no spacers are shown.

The bit lines 6 may include EPROM cells, if orthogonally intersected at the top by a plurality of parallel spaced conductive strips 12.

Said plurality of conductive strips 12 are customarily referred to as the word lines.

Each bit line 6 deposited onto the semiconductor substrate 1 in predetermined areas thereof, comprises: a first thin oxide layer referred to as the tunnel or gate oxide; a second layer 3 of polysilicon, also referred to as the polyl; a third, isolating layer 4, typically of ONO; and a fourth layer 5 of polysilicon, also referred to as the poly cap.

The method of depositing a dielectric ply structure according to this invention will now be described with specific reference to the problem of planarizing an architecture 8 wherein a plurality of bit lines 6 can be used to provide EPROM cells.

The deposition method proposed herein can ensure the filling of the gaps 7 between the plurality of bit lines 6, thereby ensuring good surface planarity and a planarized architecture 19.

A conductive layer is deposited onto this architecture 19 which is free of mechanical failures or slenderized sections.

The inventive method provides for the deposition of a first dielectric layer 17 which is grown under predetermined conditions, effective to prevent the development of cracks or micro-voids.

The thickness of the layer 17 is illustratively of 500Å to 3,000Å, enough to isolate the plurality of bit lines 6 from one another and fill the gaps 7 therebetween.

Subsequently, as shown in Figure 6A, the deposition of a second dielectric layer 18 of the BPSG type is performed to planarize the surface of the semiconductor substrate and fill the gaps 7 between bit lines 6.

The thickness of this second layer 18 is illustratively in the range of 1000Å to 6000Å, using a chemical composition with a low concentration of phosphorus and a high concentration of boron.

The high boron concentration allows the melting temperature of the layer 18 to be kept low, so that the deposited material can be subjected to annealing and softening thermal cycles at lower temperatures.

The results of experiments carried out by the inventor show that a boron and phosphorus concentration of 4% is specially suitable.

Advantageously, in order to optimize the planarity of the second dielectric layer 18 of the BPSG type, its deposition step is followed by a thermal reflowing operation obtained either rapid thermal annealing cycles or quick bakings in an oven.

The thermal reflowing of the deposited material is arranged to occur under controlled temperature conditions within the range of 900°C to 1000°C in the presence of gaseous species in the flow, such as oxygen, nitrogen or mixtures thereof.

The final step of the inventive deposition method further involves a partial etching of the second planarized dielectric layer 18 by plasma techniques.

This etching, as shown in Figure 6B, is continued until each bit line 6 is partially exposed so as to confine the second planarized dielectric layer 18 to just the regions 7 between bit lines.

A feature of this etching is its selectivity in the respect of the polysilicon material, a prerequisite to ensure that the layers 2, 3, 4, 5 making up the bit lines are not etched away.

However, where the polysilicon layer 5 thickness is substantial, this selectivity would no longer be needed, since planarity is improved already by a partial removal of the layer 5.

It has also been found experimentally that the selective etching by plasma techniques can better fill the above demands when conducted with gas mixtures which comprise carbon tetrafluoride (CF₄) and carbon trifluoride (CHF₃).

A technical expedient to improve the planarity levels of the semiconductor substrate, as obtained with the deposition method of this invention, is to have the bit lines 6 formed with definite thicknesses.

In particular, it has been found experimentally that having a layer 5 of poly cap deposited over the ONO isolation layer 4 to a thickness of 2,000 to 4,000Å, is a condition that affords superior levels of planarity.

The teaching provided by this Patent Application allows a surface planarization to be achieved which makes the deposition possible, over a non-planar integrated architecture, of a conductive layer free of mechanical ruptures in the deposited film or shrinkages in its cross-section which would affect the reliability of the electronic device being formed.

In relation to a specific application, wherein the planarized architecture 19 previously described is used to produce FLASH memory cells having a matrix-like topography, the proposed deposition method provides an additional teaching.

This additional teaching is materialized by a further step, appended consecutively to the process steps described thus far, which affords optimum utilization of the surface planarization already achieved.

It is not infrequent, in fact, for the non-volatile memory cell forming process to include photolithographic and dry-wet etching operations which involve repeated flushing with acqueous-acidic solutions prior to depositing the layers that will make up a word line. This, while being necessary to remove the resist from protected areas, is harmful to planarity in that some of the layer under the resist is also affected.

The net result is that micro-voids are formed which make the deposition of a conductive overlayer impracticable.

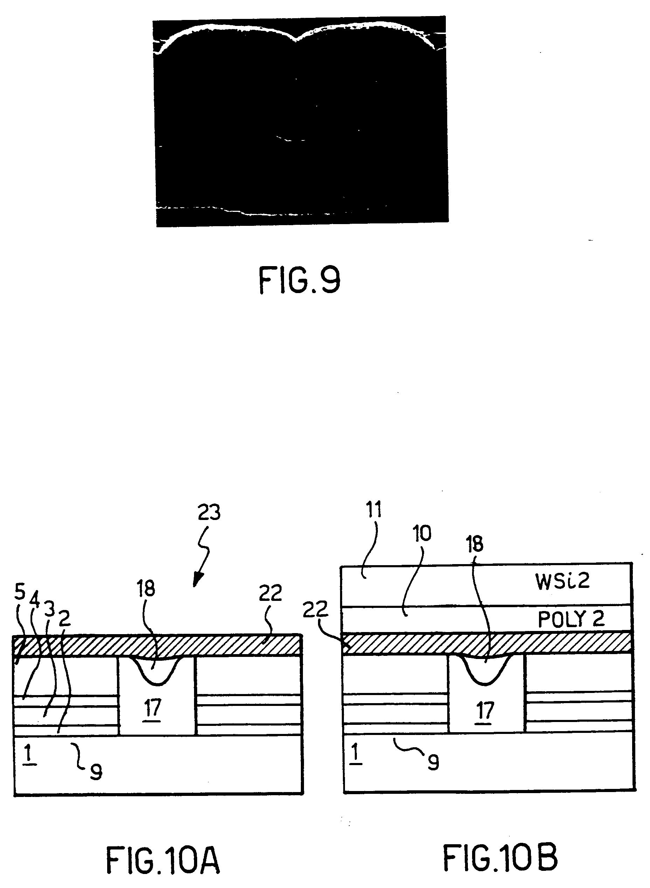

Figure 9 illustrates an instance where, subsequently to a flushing operation on the planarized architecture 19, a conductive layer is deposited, as highlighted by the white trace visible in Figure 9.

It can be seen that this layer penetrates the micro-voids formed in the surface.

To avoid problems of this kind, once surface planarity is achieved by the deposition method previously described, a step is immediately carried out, as shown in Figure 10A, of depositing a third conductive layer 22 of polysilicon whose thickness varies illustratively between 300[nm] and 500[nm], to protect the planarized architecture 19.

At this point, the standard process flows employed to make non-volatile memory cells can follow one another without impairing the planarity of the architecture 19.

Thus, it becomes possible to deposit a resist layer whereon the areas can be defined from which the protective polysilicon 22 and underlying poly cap layer 5 are to be removed.

Thereafter, a dry-wet etching operation will remove said materials from the areas unprotected by resist.

Flushing with an aqueous-acidic solution will then be necessary to remove the resist from the protected areas.

With this approach, the planarizing dielectric layer 18 of BPSG can no longer be etched away because of the protection afforded by a protective layer 22 of polysilicon.

Thereafter, if a tablecloth topography including EPROM cells is to be formed from the planarized and protected architecture 23, the following steps should be carried out:
p-ISO and LUS-channel implanting;
depositing a fourth conductive layer 10 of polysilicon, referenced as poly2 in Figure 10B;
depositing a fifth conductive layer 11 including silicide of tungsten;
photolithographing and selectively etching to define the word lines.

In another modified embodiment of the deposition method according to the invention, the first dielectric layer 17 isolating the non-planarized architecture 8 may be replaced, as shown in Figure 7A, with an oxide layer 20 to be grown thermally on the overlying regions of the semiconductor substrate bounded by the bit lines 6.

This modification is meant to illustrate a further embodiment of the principles on which this invention is based.

In particular, the possibility is shown of achieving comparable levels of planarity without resorting to dielectric layers of the TEOS type which may develop cracks or micro-voids, unless grown under definite conditions of pressure and temperature.

To summarize, the deposition method of this invention allows the surface of semiconductor substrates to be planarized, and gaps 7 filled which may measure less than 0.6 µm in size and have substantial depths, in a way hitherto impossible to achieve with the deposition of films or layers by the usual chemical vapor deposition (CVD) methods.

It should be further noted that the thermal treatments provided by the deposition method of this invention are consistent with the integration of electronic devices with CMOS technology, since the amounts of heat and the temperatures required to promote reflowing of the deposited layers are quite moderate.

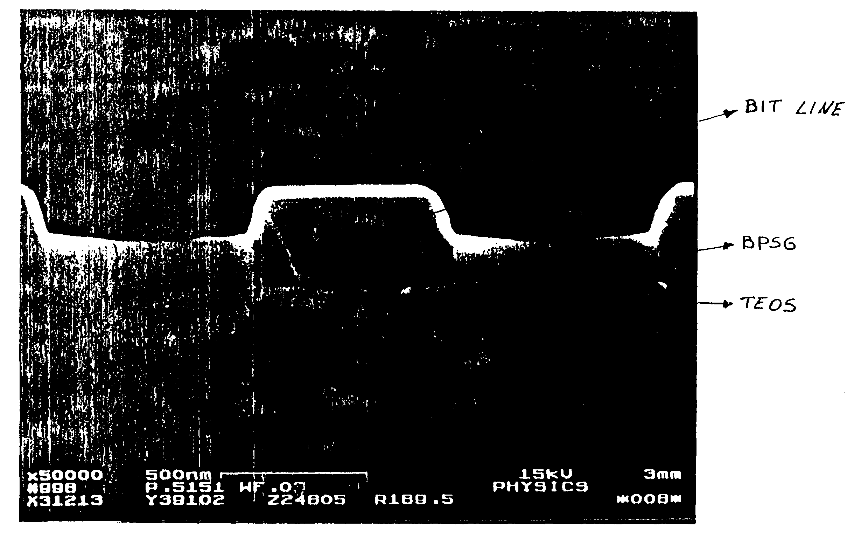

All of the above advantages afforded by the deposition method in accordance with the principles of this invention can be recognized and ascertained by TEM and SEM analyses at the electronic microscope, as illustrated by Figure 11, of semiconductor substrates having planarization dielectric ply structures which have been grown using the method, and modifications thereof, described hereinabove.

## Claims

1. A method of depositing a dielectric ply structure to improve the planarity of electronic devices integrated on a semiconductor substrate, which devices include a plurality of active elements having gate regions laid across the substrate as discrete parallel lines, such as the bit lines of memory cells, said lines being isolated from one another by a first dielectric layer which also fills the gaps therebetween, characterized in that it comprises the following steps:
depositing a second dielectric layer to planarize the surface of the semiconductor substrate;
rapid thermal annealing to reflow the second dielectric layer.

2. A deposition method according to Claim 1, characterized in that said second, planarizing dielectric layer is of the BPSG type.

3. A deposition method according to Claim 1, characterized in that said rapid thermal annealing treatment is followed by a plasma etching step to remove first and second dielectric layers and have said second planarizing dielectric layer confined to the gaps between said line plurality.

4. A deposition method according to Claim 3, characterized in that said plasma etching step is selective in the respect of the polysilicon.

5. A deposition method according to the preamble of Claim 1, characterized in that said first dielectric layer is an oxide deposited by TEOS technique.

6. A deposition method according to the preamble of Claim 1, characterized in that the thickness of said first dielectric layer is within the range of 500Å to 3000Å.

7. A deposition method according to Claim 1, characterized in that the thickness of said second, planarizing dielectric layer is within the range of 1000Å to 6000Å.

8. A deposition method according to Claim 1, characterized in that said second dielectric layer has high boron and low phosphorus contents.

9. A deposition method according to Claim 8, characterized in that said second dielectric layer has a boron and phosphorus concentration of 4%.

10. A deposition method according to Claim 1, characterized in that said rapid thermal annealing treatment is carried out at a temperature in the 900° to 1000°C range.

11. A deposition method according to Claim 1, characterized in that said rapid thermal annealing treatment is carried out under a stream of gas or gas mixtures.

12. A deposition method according to Claim 11, characterized in that said gas mixtures comprise oxygen or nitrogen.

13. A deposition method according to Claim 1, characterized in that the plasma etching step carried out on the second planarized dielectric layer is followed by the deposition of a third protective layer to fully cover said second planarizing dielectric layer.

14. A deposition method according to Claim 13, characterized in that said third layer is a conductive layer.

15. A deposition method according to Claim 14, characterized in that said third layer is a polysilicon layer.

16. A deposition method according to Claim 13, characterized in that the thickness of said third protective layer is within the range of 300[nm] to 500[nm].

17. A dielectric ply structure for planarizing electronic devices integrated on a semiconductor substrate, which devices include a plurality of active elements having gate regions laid across the substrate as discrete parallel lines, such as the bit lines of memory cells, said lines being isolated from one another by a first dielectric layer which also fills the gaps therebetween, characterized in that it comprises:
a second planarization dielectric layer of the BPSG type fully covering said first isolation dielectric layer.

18. A dielectric ply structure according to Claim 17, characterized in that the thickness of said second planarization dielectric layer is within the range of 1000Å to 6000Å.

19. A dielectric ply structure according to Claim 17, characterized in that it comprises a protective layer fully covering said second planarization dielectric layer.

20. A dielectric ply structure according to Claim 19, characterized in that said protective layer is made of a conductive material.

21. A dielectric ply structure according to Claim 20, characterized in that said protective layer is a polysilicon layer.

22. A method of depositing a dielectric ply structure to improve the planarity of electronic devices integrated on a semiconductor substrate, which devices include a plurality of active elements having gate regions laid across the substrate as discrete parallel lines, such as the bit lines of memory cells, said lines being isolated from one another by a first dielectric layer which also fills the gaps therebetween, characterized in that it comprises the following steps:
growing a first layer of dielectric oxide on the substrate regions intervening between said lines;
depositing a second dielectric layer to planarize the surface of the semiconductor substrate;
rapid thermal annealing to reflow the second dielectric layer.

23. A deposition method according to Claim 22, characterized in that said first layer of dielectric oxide is 500Å thick.
